# FASCICULE DE BREVET EUROPEEN

(11) **EP 2 585 628 B1**
(45) Date de publication et mention de la délivrance du brevet: **10.03.2021**
(21) Numéro de dépôt: 11743254.2
(22) Date de dépôt: 23.06.2011
(51) Int. Cl.: D02G 3/36, D02G 3/44, G06K 19/077, H01L 21/98, H01L 25/065, H01L 21/67

(54) **INCORPORATION D'ÉLÉMENTS À PUCE DANS UN FIL GUIPÉ**
EINBAU VON CHIP-ELEMENTEN IN EINEN UMMANTELTEN DRAHT
INCLUSION OF CHIP ELEMENTS IN A SHEATHED WIRE

(30) Priorité: 24.06.2010 FR 1002656
(43) Date de publication de la demande: 01.05.2013
(73) Titulaire: Commissariat à l'Énergie Atomique et aux Énergies Alternatives, 75015 Paris (FR)
(72) Inventeur: BRUN, Jean, F-38800 Champagnier (FR); LANCON, Laurent, F-07200 Saint-Étienne-de-Fontbellon (FR); VICARD, Dominique, F-38190 Bernin (FR)
(74) Mandataire: Talbot, Alexandre
(86) Numéro de dépôt international: PCT/FR2011/000359
(87) Numéro de publication internationale: WO 2011/161336

(56) Documents cités:
- WO-A1-98/33155
- WO-A1-2004/073130
- WO-A2-2008/080245
- WO-A2-2009/004243
- US-A- 3 644 866

## Description

### Domaine technique de l'invention

L'invention est relative à des éléments à puce microélectronique, dont la plus grande dimension peut être inférieure au millimètre. L'invention concerne plus particulièrement un procédé de conditionnement de tels éléments à puce pour en faciliter le stockage et la manipulation.

### État de la technique

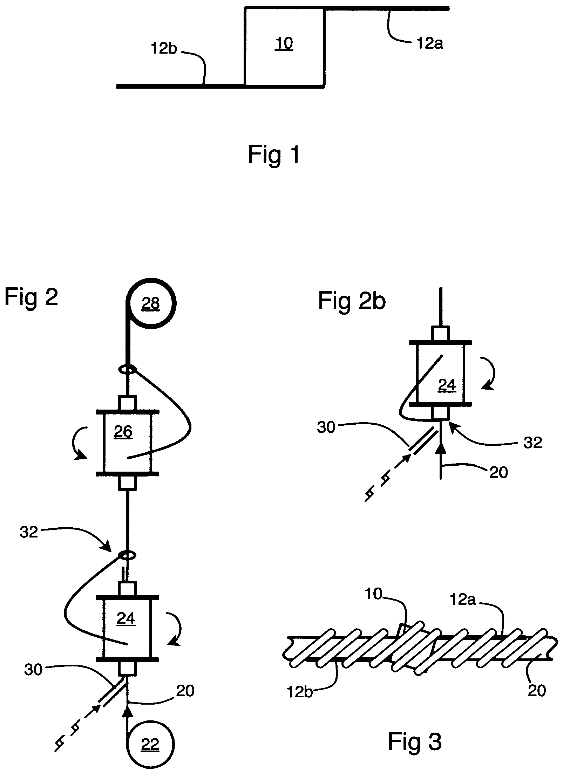

La figure 1 représente schématiquement un dispositif d'émission-réception radiofréquence miniaturisé, servant par exemple à une identification sans contact (dispositif de type RFID). Le dispositif comprend un élément à puce 10, de forme générale parallélépipédique, incorporant une puce qui intègre toutes les fonctions RFID.

Le dispositif comprend une antenne dipôle formée de deux tronçons de fil conducteur 12a et 12b. Ces tronçons, solidaires de deux faces opposées de l'élément 10, sont connectés à des bornes de la puce et partent dans des directions opposées.

Le plus grand côté de l'élément à puce 10 pouvant être inférieur à 1 mm, ces dispositifs ne sont pas fabriqués et manipulés par les procédés utilisés pour des dispositifs plus grands.

La demande de brevet WO2009004243 décrit un exemple de procédé de réalisation de dispositifs RFID du type de la figure 1. Une fois réalisés, ces dispositifs doivent être incorporés dans les objets à identifier. Cela pose des problèmes de manipulation, car les antennes doivent rester sensiblement rectilignes, ou du moins ne pas être tordues jusqu'à entrer en court-circuit.

Le document WO2008/080245 décrit une structure filaire qui comporte des composants électroniques intégrés. Un composant électronique bipolaire possède deux zones de connexion électriques connectées respectivement à deux brins. Le composant électronique bipolaire est fixé à un fil textile au moyen d'un connecteur. Le fil textile est plus court que les deux brins. Le document décrit également un mode de réalisation où deux fils textiles s'enroulent autour du composant électronique bipolaire relié aux deux brins.

### Résumé de l'invention

Ainsi, on a besoin d'une solution pour améliorer le maintien d'éléments à puce individualisés, de très petite taille, notamment lorsque ceux-ci sont munis de tronçons de fil que l'on souhaite conserver sensiblement rectilignes.

Pour tendre à satisfaire ce besoin, on prévoit un procédé de réalisation d'un fil guipé selon la revendication 1.

On prévoit également un fil guipé comprenant une âme autour de laquelle est enroulée une fibre de gainage et défini dans la revendication 2.

### Description sommaire des dessins

D'autres avantages et caractéristiques ressortiront plus clairement de la description qui va suivre de modes particuliers de réalisation donnés à titre d'exemples non limitatifs et illustrés à l'aide des dessins annexés, dans lesquels :
- la figure 1, précédemment décrite, représente schématiquement un élément à puce muni d'une antenne dipolaire ;
- la figure 2 représente schématiquement une installation de guipage servant à incorporer des éléments à puce espacés dans un fil continu ;
- le figure 2b représente une variante d'un détail de l'installation de la figure 2 ;
- la figure 3 représente un tronçon de fil guipé réalisé à l'aide de l'installation de la figure 2 ;
- les figure 4A et 4B représentent, en vue de dessus et en vue de bout, des éléments à puce conditionnés sous forme de chaîne ;
- la figure 5 représente schématiquement un mode de réalisation de chaîne d'éléments à puce facilitant l'automatisation de l'incorporation des éléments dans un fil guipé ; et
- la figure 6 représente un mode de réalisation d'élément à puce permettant de réaliser une entaille dans un fil support.

### Description d'un mode de réalisation préféré de l'invention

Afin de faciliter la manipulation d'éléments à puce individualisés de très petite taille (pouvant être inférieure à 1 mm), on propose de les incorporer de manière espacée dans un fil guipé. Les éléments à puce seront pris entre l'âme du fil et une fibre de gainage enroulée en hélice autour de l'âme.

Afin que les éléments à puce ne tendent pas à s'échapper entre les spires consécutives de la fibre de gainage, ceux-ci seront munis de tronçons de fil également pris entre l'âme et la fibre de gainage. Ces tronçons de fil pourront avantageusement être les antennes dipôle d'éléments à puce intégrant des fonctions d'émission-réception radiofréquence ou RFID.

Le fil guipé, enroulé sur une bobine, est facilement manipulable. Outre le fait que le fil pourra servir à confectionner des tissus, il pourra être découpé et incorporé dans d'autres objets, manuellement ou de façon automatisée, en limitant les risques de perdre les éléments à puce ou de tordre les antennes dipôle.

La figure 2 représente schématiquement une installation de guipage classique pouvant servir à incorporer des éléments à puce dans un fil guipé moyennant de simples modifications. Une telle installation est décrite, par exemple, dans le brevet US4262480.

Une âme 20 se déroule d'une bobine d'alimentation 22, traverse axialement deux rouleaux successifs, 24 et 26, et finit enroulée sur une bobine réceptrice 28. Chacun des rouleaux 24 et 26 emmagasine une fibre de gainage et est associé à un mécanisme tournant autour de l'âme en cours de défilement, et enroulant autour de celle-ci la fibre de gainage. Les deux mécanismes d'enroulement tournent en sens inverse, d'où il résulte que le fil guipé sortant comporte deux couches de fibre de gainage, formées d'hélices de sens opposés. Le rapport des vitesses de défilement de l'âme et de rotation des mécanismes d'enroulement définit le pas des hélices.

Comme cela est représenté, il est classique de travailler à la verticale de bas en haut, c'est-à-dire que la bobine d'alimentation 22 se trouve en bas, et la bobine de réception 28 en haut. Les mécanismes d'enroulement sont, dans la figure 2, prévus pour enrouler la fibre de gainage autour de l'âme 20 à la sortie des rouleaux (dans le sens de défilement de l'âme).

Afin d'incorporer des éléments à puce dans le fil en cours de formation, on prévoit un dispositif d'insertion 30, de préférence au niveau du premier rouleau 24. Ce dispositif d'insertion, par exemple sous la forme d'un tube de diamètre adapté aux éléments à puce 10, guide ceux-ci jusqu'à une zone de guipage 32 où la fibre de gainage du rouleau 24 est enroulée autour de l'âme 20. Ce tube traverse le rouleau 24 de bas en haut et débouche à proximité de la zone 32.

Les éléments 10 individuels sont, par exemple, projetés à l'aide d'air comprimé à travers le tube 30 jusqu'à la zone 32, où ils sont happés par la fibre de gainage en cours d'enroulement.

La figure 2b représente une autre configuration possible, classique, du rouleau 24 avec son mécanisme d'enroulement. L'enroulement de la fibre de gainage autour de l'âme 20 a lieu à l'entrée du rouleau (dans le sens de défilement de l'âme 20). La zone de guipage 32 est donc située à l'entrée du rouleau 24. Cette configuration permet d'utiliser un dispositif d'insertion 30 plus court, puisqu'il ne doit plus traverser le rouleau 24. Cela facilite l'alimentation du dispositif d'insertion en éléments à puce 10.

Afin de permettre d'alimenter le dispositif d'insertion 30 par gravité, ce qui simplifierait davantage le procédé, on peut envisager d'inverser l'installation, c'est-à-dire faire défiler l'âme 20 du haut vers le bas.

La figure 3 représente un tronçon de fil guipé obtenu à la sortie du premier rouleau 24, illustrant un élément à puce 10, avec ses tronçons de fil 12a et 12b, pris entre l'âme 20 et la fibre de gainage, enroulée en hélice, provenant du rouleau 24. On cherche à avoir les tronçons de fil 12a et 12b sensiblement parallèles à l'âme 20, comme cela est représenté.

On expose ci-après un mode préféré d'acheminement des éléments à puce 10 vers la zone de guipage 32.

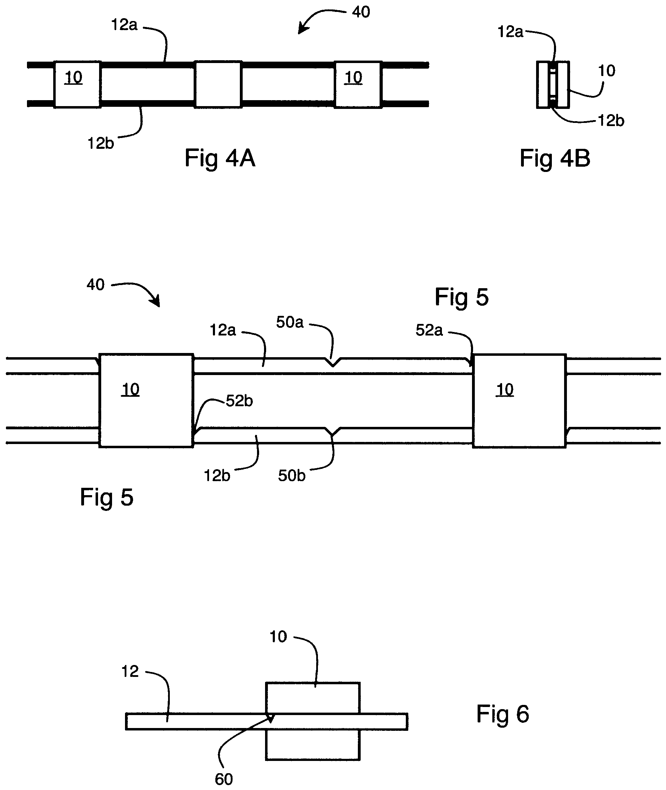

Les figures 4A et 4B représentent schématiquement une chaîne 40 d'éléments à puce microélectronique 10 réalisable, par exemple, par un procédé décrit dans la demande de brevet EP2099060.

La figure 4A représente un tronçon de la chaîne 40 en vue de dessus. Plusieurs éléments à puce 10 sont solidarisés entre deux fils support parallèles 12a et 12b.

La figure 4B représente un des éléments à puce 10 en vue de bout. L'élément est muni de deux rainures latérales dans lesquelles sont encastrés les fils support 12a et 12b. Ces rainures sont éventuellement munies de plots de connexion électrique dans le cas où les fils support sont conducteurs et servent à transmettre des signaux électriques.

Une telle chaîne 40, en choisissant des fils 12a et 12b de rigidité suffisante, pourra être poussée le long du tube d'insertion 30 en conservant l'écart entre les éléments à puce 10. L'élément 10 en bout de chaîne, lorsqu'il arrive au niveau de la zone de guipage 32, est happé par la fibre de gainage en cours d'enroulement et arraché du reste de la chaîne. (Par « élément 10», on entend ci-après l'élément à puce 10 muni de ses tronçons de fil 12, le cas échéant.)

La chaîne 40 pourra être alimentée en continu ou par intermittence à une vitesse moyenne inférieure à la vitesse de défilement de l'âme 20. Le fil guipé résultant contiendra des éléments à puce régulièrement espacés, selon un pas proportionnel au pas de la chaîne et au rapport de la vitesse de l'âme et d'alimentation de la chaîne.

Pour faciliter le défilement de la chaîne 40 dans le tube 30, on pourra munir la paroi du tube, longitudinalement, d'une série de canaux inclinés dans le sens de défilement de la chaîne, par lesquels on insuffle de l'air comprimé.

Avec le procédé tel que décrit jusqu'à maintenant, on maîtrise mal l'emplacement de la rupture des fils 12 de la chaîne au moment où l'élément 10 de bout de chaîne est happé. Si le tube d'insertion 30 est aligné dans le sens de défilement de l'âme 20, comme à la figure 2, la rupture peut avoir lieu n'importe où dans le tronçon de chaîne dans le tube 30.

Pour favoriser une rupture des fils 12 entre les deux éléments 10 en bout de chaîne, le tube 30 est de préférence incliné par rapport à l'axe de l'âme 20, comme cela est représenté à la figure 2b. Ainsi, la traction exercée sur l'élément 10 sortant provoque le coincement de l'élément 10 suivant entre les bords de l'orifice de sortie du tube 30. Cet élément, ainsi coincé, empêche la transmission de la traction au reste de la chaîne 40. L'élément coincé sera libéré aussitôt que la traction cesse du fait de la rupture des fils 12.

Selon une variante pour contrôler la rupture des fils, on peut prévoir à l'extrémité du tube 30 un mécanisme qui bloque l'élément 10 sur le point de sortir du tube, tandis que l'élément 10 sortant est présenté à la zone de guipage. On prévoit pour cela, par exemple, des galets souples agencés pour pincer la chaîne et l'entraîner par frottement. Le roulement des galets est arrêté à chaque passage d'un élément 10, le temps que l'élément qui le précède soit happé dans la zone de guipage.

Bien que l'on parvienne ainsi à assurer que la rupture des fils 12 ait lieu entre les deux éléments 10 en bout de chaîne, on ne maîtrise pas l'emplacement de la rupture entre ces deux éléments. Cela ne convient pas pour réaliser des antennes dipôle.

La figure 5 représente un mode de réalisation de chaîne 40 permettant une rupture maîtrisée des fils 12, notamment pour que les tronçons de fil restant solidaires de chaque élément à puce arraché aient des longueurs choisies.

Les tronçons des fils 12a et 12b entre deux éléments 10 présentent chacun une entaille, respectivement 50a et 50b. Ces entailles définissent des points de rupture préférentielle, ou amorces de rupture délibérées, destinés à céder avant tout autre point des fils lorsqu'on exerce une traction suffisante sur la chaîne 40.

Les entailles pourront être faites de diverses manières, par exemple par un trait de scie, l'enfoncement d'une lame, une corrosion partielle, ou une fusion partielle.

Les entailles 50a et 50b ont été représentées au centre des tronçons de fil entre deux éléments à puce 10. Cela convient dans une situation où les fils ne jouent aucun rôle par la suite, si ce n'est de participer au maintien des éléments à puce individuels entre l'âme et la fibre de gainage du fil guipé (figure 3).

Si on souhaite incorporer des groupes de plusieurs éléments à puce consécutifs interconnectés dans le fil guipé, les fils 12 seront entaillés seulement entre le dernier élément à puce d'un premier groupe et le premier élément du groupe suivant. L'alimentation de la chaîne est alors effectuée par pas correspondant à la longueur des groupes. La synchronisation des pas est telle que le groupe sortant est alimenté à la vitesse de défilement de l'âme 20, et l'alimentation s'arrête lorsque le premier élément à puce du groupe suivant atteint le bord de l'orifice de sortie du tube d'insertion 30. Alors le groupe sortant est arraché du reste de la chaîne au niveau des entailles dans les tronçons de fil devant l'élément au bord de l'orifice.

Si les fils doivent servir d'antenne dipôle à un élément RFID, on prévoit plutôt des entailles 52a et 52b des côtés opposés des tronçons de fil 12a et 12b. Ainsi, en exerçant une traction sur la chaîne, les éléments 10 se désolidarisent avec des tronçons d'antenne partant en sens opposés, comme cela est représenté à la figure 1. Ceci sous-entend que le pas des éléments 10 dans la chaîne correspond à la longueur d'antenne.

La figure 6 représente en vue de côté un mode de réalisation d'élément à puce 10 permettant d'entailler le fil 12 à la réalisation de la chaîne. L'élément 10 comporte une rainure dans laquelle est insérée le fil 12 (12a ou 12b). L'une des parois latérales de la rainure comporte, au niveau d'une extrémité de la rainure, une nervure acérée 60 s'étendant sur une partie de la largeur de la rainure. Cette nervure réalise une entaille dans le fil 12 au moment où celui-ci est solidarisé de l'élément à puce. En munissant les deux rainures de chaque élément à puce d'une telle nervure, on pourra réaliser les entailles 52a et 52b de la figure 5 sans étape supplémentaire.

## Revendications

1. Procédé de réalisation d'un fil guipé, comprenant les étapes suivantes :
• faire défiler axialement une âme (20) par une zone de guipage (32) depuis une bobine d'alimentation (22) ;
• présenter, au niveau de la zone de guipage (32) depuis un dispositif d'insertion (30), une série d'éléments à puce microélectronique (10) chacun muni d'un tronçon de fil (12) ;
• enrouler une fibre de gainage (24) autour de l'âme (20) au niveau de la zone de guipage (32) de sorte que la fibre de gainage (24) en cours d'enroulement autour de l'âme (20) s'enroule autour d'un élément à puce microélectronique (10) de la série d'éléments à puce microélectronique (10) et son tronçon de fil (12) pour réaliser le fil guipé incorporant des éléments à puce (10) pris entre l'âme (20) et la fibre de gainage (24) et espacés le long du fil guipé;
**caractérisé en ce que** chaque élément à puce (10) est muni de deux tronçons de fil conducteur (12a, 12b) pris entre l'âme (20) et la fibre de gainage (24) sensiblement parallèles à l'âme (20), formant une antenne dipôle reliée à des circuits d'émission-réception radiofréquence intégrés à une puce de l'élément à puce (10).

2. Fil guipé comprenant une âme (20) autour de laquelle est enroulée une fibre de gainage (24), et comprenant, pris entre l'âme (20) et la fibre de gainage (24), des éléments à puce microélectronique (10) espacés le long du fil guipé, **caractérisé en ce que** chaque élément à puce (10) est muni de deux tronçons de fil conducteur (12a, 12b) également pris entre l'âme (20) et la fibre de gainage (24) sensiblement parallèles à l'âme (20), formant une antenne dipôle reliée à des circuits d'émission-réception radiofréquence intégrés à une puce de l'élément à puce (10).

3. Fil guipé selon la revendication 2, **caractérisé en ce que** chaque élément à puce (10) est muni de deux rainures dans chacune desquelles laquelle est inséré un des deux tronçons de fil conducteur (12), chaque rainure comportant au voisinage de l'une de ses extrémités une arête (60) définissant une extrémité du tronçon de fil conducteur (12) correspondant.

## Patentansprüche

1. Verfahren zur Herstellung eines ummantelten Drahtes, umfassend die folgenden Schritte:
• axiales Vorschieben einer Seele (20) durch eine Ummantelungszone (32) ausgehend von einer Versorgungsspule (22);
• Bereitstellen, im Bereich der Ummantelungszone (32), ausgehend von einer Einführvorrichtung (30), einer Reihe von Mikroelektronikchipelementen (10), die jeweils mit einem Drahtabschnitt (12) versehen sind;
• Wickeln einer Umhüllungsfaser (24) um die Seele (20) im Bereich der Ummantelungszone (32), sodass die Umhüllungsfaser (24) während des Wickelns um den Kern (20) um ein Mikroelektronikchipelement (10) der Reihe von Mikroelektronikchipelementen (10) und seinen Drahtabschnitt (12) gewickelt wird, um den ummantelten Draht herzustellen, der Chipelemente (10) einschließt, die zwischen der Seele (20) und der Umhüllungsfaser (24) eingeklemmt sind und entlang des ummantelten Drahtes voneinander beabstandet sind;
**dadurch gekennzeichnet, dass** jedes Chipelement (10) mit zwei Leitungsdrahtabschnitten (12a, 12b) versehen ist, die zwischen der Seele (20) und der Umhüllungsfaser (24) im Wesentlichen parallel zur Seele (20) eingeklemmt sind und eine Dipolantenne bilden, die mit Radiofrequenz-Sende-Empfangsschaltungen verbunden ist, die in einen Chip des Chipelements (10) integriert sind.

2. Ummantelter Draht, umfassend eine Seele (20), um die eine Umhüllungsfaser (24) gewickelt ist, und umfassend, zwischen der Seele (20) und der Umhüllungsfaser (24) eingeklemmt, Mikroelektronikchipelemente (10), die entlang des ummantelten Drahtes voneinander beabstandet sind, **dadurch gekennzeichnet, dass** jedes Chipelement (10) mit zwei Leitungsdrahtabschnitten (12a, 12b) versehen ist, die ebenfalls zwischen der Seele (20) und der Umhüllungsfaser (24) im Wesentlichen parallel zur Seele eingeklemmt (20) sind und eine Dipolantenne bilden, die mit Radiofrequenz-Sende-Empfangsschaltungen verbunden ist, die in einen Chip des Chipelements (10) integriert sind.

3. Ummantelter Draht nach Anspruch 2, **dadurch gekennzeichnet, dass** jedes Chipelement (10) mit zwei Nuten versehen ist, in die jeweils einer der zwei Leitungsdrahtabschnitte (12) eingefügt ist, wobei jede Nut in der Nähe eines ihrer Enden einen Grat (60) aufweist, der ein Ende des entsprechenden Leitungsdrahtabschnitts (12) definiert.

## Claims

1. A method for forming a sheathed wire, comprising the following steps of:
• axially advancing a core (20) through a sheathing zone (32) from a supply spool (22);
• providing, in the sheathing zone (32) from an insertion device (30), a series of microelectronic chip elements (10) each provided with a wire section (12),
• wrapping a sheathing fiber (24) around the core (20) in the sheathing zone (32) in such a way that the sheathing fiber (24) that wraps around the core (20) wraps around a microelectronic chip element (10) of the series of microelectronic chip elements (10) and its wire section (12) to form a sheathed wire incorporating chip elements (10) caught between the core (20) and the sheathing fiber (24) and spaced-apart along the sheathed wire;
**characterized in that** each chip element (10) is provided with two sections of conductive wire (12a, 12b) also caught between the core (20) and the sheathing fiber (24) substantially parallel to the core (20), forming a dipole antenna connected to radio frequency transmit-receive circuits integrated to a chip of the chip element (10).

2. A sheathed wire comprising a core (20) around which a sheathing fiber (24) is wound, and comprising, sandwiched between the core (20) and the sheathing fiber (24), microelectronic chip elements (10) spaced along the sheathed wire, **characterized in that** each chip element (10) is provided with two sections of conductive wire (12a, 12b) also caught between the core (20) and the sheathing fiber (24) substantially parallel to the core (20), forming a dipole antenna connected to radio frequency transmit-receive circuits integrated to a chip of the chip element (10).

3. The sheathed wire according to claim 2, **characterized in that** each chip element (10) is provided with two grooves into each of which is inserted one of the two sections of conductive wire (12), each groove comprising in the vicinity of one of its ends a ridge (60) defining one end of the corresponding section of conductive wire (12).
